# FASCICULE DE BREVET EUROPEEN

(11) **EP 2 810 334 B1**
(45) Date de publication et mention de la délivrance du brevet: **03.10.2018**
(21) Numéro de dépôt: 13701097.1
(22) Date de dépôt: 24.01.2013
(51) Int. Cl.: H01M 10/48, H04B 3/54, H01M 10/42

(54) **SYSTEME DE COMMUNICATION DANS UNE BATTERIE ELECTRIQUE**
KOMMUNIKATIONSSYSTEM IN EINER ELEKTRISCHEN BATTERIE
COMMUNICATION SYSTEM IN AN ELECTRICAL BATTERY

(30) Priorité: 31.01.2012 FR 1250871
(43) Date de publication de la demande: 10.12.2014
(73) Titulaire: Renault S.A.S., 92100 Boulogne-Billancourt (FR)
(72) Inventeur: BACQUET, Sylvain, F-38470 Chasselay (FR)
(86) Numéro de dépôt international: PCT/EP2013/051368
(87) Numéro de publication internationale: WO 2013/113617

(56) Documents cités:
- EP-A1- 2 296 214
- JP-A- 2005 063 956
- US-A1- 2010 079 146
- US-A1- 2011 205 035
- US-B1- 7 059 769

## Description

### Domaine de l'invention

La présente invention concerne des communications entre un dispositif maître et un ou plusieurs dispositifs esclaves dans une batterie électrique.

### Exposé de l'art antérieur

Une batterie électrique est un groupement de plusieurs cellules élémentaires (piles, accumulateurs, etc.) reliées en série et/ou en parallèle entre deux noeuds ou bornes de fourniture d'une tension continue.

Les cellules de la batterie sont généralement logées dans un boîtier de protection ne laissant accessible que deux cosses respectivement connectées aux deux bornes de la batterie.

Dans certaines applications, par exemple dans le domaine des batteries pour véhicules électriques, on souhaite pouvoir interroger des capteurs ou autres dispositifs électroniques situés à l'intérieur du boîtier de protection, par exemple des capteurs de température placés sur des cellules de la batterie, des étiquettes électroniques d'identification, ou tout autre type de dispositif.

Pour cela, on peut prévoir une communication filaire entre un lecteur (dispositif maître), situé à l'extérieur du boîtier de la batterie, et les capteurs ou autres objets à interroger (dispositifs esclaves), situés à l'intérieur du boîtier. Un inconvénient réside dans la nécessité de faire sortir des câbles à l'extérieur du boîtier, ce qui implique de prévoir des connecteurs et un risque d'arrachage. En outre, le nombre de câbles nécessaires à l'instrumentation d'une batterie peut être important, entraînant une augmentation non négligeable du prix de revient de la batterie. De plus, les câbles peuvent capter des perturbations électromagnétiques susceptibles d'altérer les signaux de données entre le dispositif maître et les dispositifs esclaves.

Pour éviter les inconvénients d'une communication filaire, on pourrait utiliser des communications par ondes radio (sans contact) entre le dispositif maître et les dispositifs esclaves. Toutefois, l'environnement, souvent fortement métallique, rend de telles communications difficiles et aléatoires.

Il serait souhaitable de pouvoir disposer d'un moyen fiable et peu coûteux pour communiquer avec des capteurs ou autres dispositifs situés à l'intérieur d'une batterie.

Les documents US2010/0079146, EP2296214 et US7059769 décrivent des exemples de systèmes de communication dans des batteries électriques.

La demande de brevet US 2011/205035 A1 décrit un dispositif correspondant au préambule de la revendication 1.

### Résumé

Ainsi, un objet d'un mode de réalisation de la présente invention vise un système de communication entre un dispositif maître et au moins un dispositif esclave dans une batterie électrique, ce système palliant au moins en partie certains des inconvénients des systèmes connus.

Un autre objet d'un mode de réalisation de la présente invention est de prévoir un système de communication plus fiable que les systèmes connus.

Un autre objet d'un mode de réalisation de la présente invention est de prévoir un système de communication moins onéreux que les systèmes connus.

Un autre objet d'un mode de réalisation de la présente invention est de prévoir un procédé de communication entre un dispositif maître et un ou plusieurs dispositifs esclaves dans une batterie électrique.

Ainsi, un mode de réalisation de la présente invention prévoit un système comprenant : une batterie dans laquelle une pluralité de cellules élémentaires sont reliées entre deux premiers noeuds ; un premier dispositif adapté à appliquer un signal alternatif aux premiers noeuds ; au moins un deuxième dispositif connecté à deux deuxièmes noeuds de la pluralité de cellules ; et au moins un ensemble résonant dont un élément inductif comporte l'inductance propre de la batterie entre les deuxièmes noeuds.

Selon la présente invention, l'ensemble résonant comporte au moins un élément capacitif dudit au moins un deuxième dispositif.

Selon la présente invention, ledit au moins un deuxième dispositif est adapté à communiquer avec le premier dispositif par modulation dudit signal alternatif vu par les deuxièmes noeuds.

Selon la présente invention, la fréquence de résonance dudit ensemble résonant est approximativement égale à la fréquence dudit signal alternatif.

Selon un mode de réalisation de la présente invention, la fréquence de résonance dudit ensemble résonant est comprise entre 30 kHz et 30 MHz.

Selon un mode de réalisation de la présente invention, les deuxièmes noeuds sont deux bornes de puissance d'une même cellule élémentaire.

Selon un mode de réalisation de la présente invention, les cellules de la batterie sont connectées en série entre lesdits premiers noeuds.

Selon un mode de réalisation de la présente invention, les cellules de la batterie sont connectées en parallèle entre les premiers noeuds.

Selon un mode de réalisation de la présente invention, ledit au moins un deuxième dispositif comprend un circuit de traitement comportant deux troisièmes noeuds, ledit au moins un deuxième dispositif comportant des condensateurs d'isolement entre les troisièmes noeuds et les deuxièmes noeuds.

Selon un mode de réalisation de la présente invention, le premier dispositif comprend un générateur alternatif et un transformateur d'impédance entre ledit générateur et lesdits premiers noeuds.

Selon un mode de réalisation de la présente invention, le premier dispositif comprend des condensateurs d'accord en fréquence et des condensateurs d'isolement entre ledit transformateur et lesdits premiers noeuds.

La présente invention prévoit aussi une batterie électrique comportant : une pluralité de cellules élémentaires reliées entre deux premiers noeuds ; au moins un dispositif connecté à deux deuxième noeuds de ladite pluralité de cellules ; et au moins un ensemble résonant dont un élément inductif comporte l'inductance propre de la batterie entre lesdits deuxièmes noeuds.

Selon la présente invention, ledit au moins un dispositif est adapté à moduler un signal alternatif reçu par les deuxièmes noeuds.

Selon un mode de réalisation de la présente invention, l'ensemble résonant comporte au moins un élément capacitif dudit au moins un dispositif.

Selon un mode de réalisation de la présente invention, ledit au moins un dispositif est situé à l'intérieur d'une cellule élémentaire de la batterie.

Selon un mode de réalisation de la présente invention, ledit au moins un dispositif comprend un capteur apte à mesurer la température de l'électrolyte de la cellule.

Selon la présente invention, une pluralité de cellules élémentaires sont reliées entre deux premiers noeuds, entre un premier dispositif relié auxdits premiers noeuds et au moins un deuxième dispositif connecté à deux deuxièmes noeuds de ladite pluralité de cellules, ce procédé comportant les étapes suivantes :
côté premier dispositif, appliquer un signal alternatif auxdits premiers noeuds ; et
côté deuxième dispositif, recevoir le signal alternatif par l'intermédiaire d'au moins un ensemble résonant dont un élément inductif comporte l'inductance propre de la batterie entre les deuxièmes noeuds, et moduler ledit signal.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
la figure 1 est une vue en perspective représentant schématiquement un mode de réalisation d'un système de communication entre un dispositif maître et un dispositif esclave inclus dans une batterie électrique ;
la figure 2 est un schéma électrique illustrant un mode de réalisation d'un dispositif esclave associé à une cellule élémentaire d'une batterie électrique ;
la figure 3 est un schéma électrique illustrant une variante de réalisation du dispositif esclave de la figure 2 ;
la figure 4 est un schéma électrique illustrant un mode de réalisation d'un système de communication entre un dispositif maître, et des dispositifs esclaves inclus dans une batterie électrique dans laquelle des cellules élémentaires sont reliées en série ; et
la figure 5 est un schéma électrique illustrant un mode de réalisation d'un système de communication entre un dispositif maître, et des dispositifs esclaves dans une batterie électrique dans laquelle des cellules élémentaires sont reliées en parallèle.

### Description détaillée

De mêmes éléments ont été désignés par de mêmes références aux différentes figures. Par souci de clarté, seuls les éléments utiles à la compréhension de l'invention ont été représentés et seront décrits. En particulier, les fonctions des dispositifs esclaves n'ont pas été détaillées, les modes de réalisation étant compatibles avec les dispositifs électroniques usuels susceptibles d'être placés à l'intérieur d'une batterie électrique.

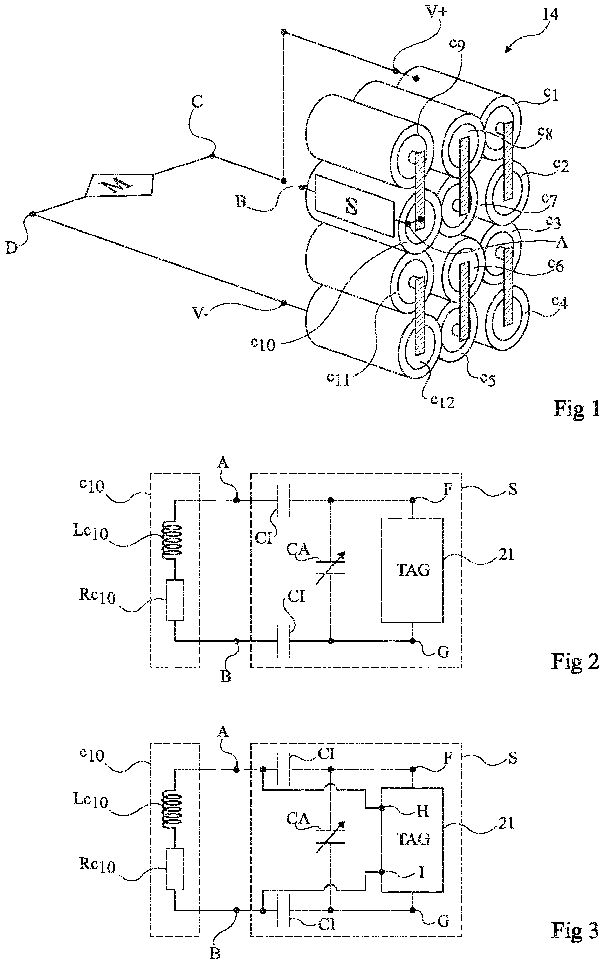

La figure 1 est une vue en perspective représentant schématiquement un exemple d'un mode de réalisation d'un système de communication entre un dispositif maître M, ou lecteur, et au moins un dispositif esclave S dans une batterie électrique 14. Dans cet exemple, la batterie 14 comporte douze cellules élémentaires c₁ à c₁₂ connectées en série entre des bornes V+ et V- de fourniture d'une tension continue. Le dispositif esclave S comprend par exemple un capteur de température ou une étiquette électronique d'identification, et est connecté aux bornes d'une cellule élémentaire de la batterie (la cellule c₁₀ dans cet exemple) par l'intermédiaire de deux contacts A et B. Le dispositif maître M, est connecté aux bornes principales V+ et V- de la batterie 14 par l'intermédiaire de deux contacts C et D.

Selon un aspect du mode de réalisation décrit, le dispositif maître M est adapté à appliquer un signal alternatif sur les bornes principales V+ et V- de la batterie, c'est-à-dire à émettre, sur le chemin de puissance de la batterie, un signal alternatif se superposant à la tension continue de la batterie. Le dispositif esclave S, connecté en parallèle d'une portion du chemin de puissance de la batterie, est adapté à communiquer avec le dispositif M en démodulant et/ou en modulant le signal alternatif vu sur ses bornes A et B.

Par souci de clarté, aucun boîtier de protection de la batterie 14 n'a été représenté sur la figure 1. Si un boîtier de protection devait être prévu, le dispositif esclave S pourrait être logé à l'intérieur du boîtier, et le dispositif maître M pourrait être situé à l'extérieur du boîtier, et connecté aux bornes V+ et V-.

La figure 2 est un schéma électrique illustrant de façon plus détaillée un mode de réalisation du dispositif esclave S connecté à la cellule élémentaire c₁₀ de la batterie électrique 14 de la figure 1.

Du point de vue du signal alternatif émis par le dispositif maître M (non visible sur la figure 2) et propagé sur le chemin de puissance de la batterie, la cellule élémentaire c₁₀ se comporte comme une inductance Lc₁₀ en série avec une résistance Rc₁₀. Les valeurs de l'inductance Lc₁₀ et de la résistance Rc₁₀ dépendent, entre autres facteurs de la technologie de réalisation de la cellule c_{10'} de sa structure, etc.

Selon un aspect du mode de réalisation décrit, le dispositif esclave S forme, avec l'inductance propre Lc₁₀ et la résistance propre Rc₁₀ de la cellule c₁₀ aux bornes de laquelle il est connecté, un ensemble résonant.

Le dispositif esclave S comprend un circuit principal 21 (TAG), ou circuit de traitement, comportant deux bornes F et G d'application d'un signal alternatif. Deux condensateurs d'isolement (ou de découplage) CI sont prévus respectivement entre la borne A et la borne F, et entre la borne B et la borne G, pour empêcher que la tension continue de la cellule c₁₀ ne soit appliquée aux bornes F et G du circuit 21. Le circuit 21 ne voit donc à ses bornes que le signal alternatif propagé par le dispositif maître M sur le chemin de puissance de la batterie. Les condensateurs CI permettent en particulier d'éviter que la cellule c₁₀ ne se décharge dans le circuit 21. Le dispositif S comporte en outre un condensateur CA d'accord de la fréquence de résonance de l'ensemble formé par le dispositif S, l'inductance Lc_{10'} et la résistance Rc₁₀. Dans cet exemple, le condensateur CA est connecté entre les bornes F et G. Le condensateur CA est par exemple un condensateur à capacité variable. La capacité CA est choisie en fonction de la fréquence du signal alternatif appliqué par le dispositif M aux bornes V+ et V- de la batterie, de façon que l'ensemble résonant formé par le dispositif S et la cellule c₁₀ résonne à cette fréquence. Ainsi, le signal alternatif vu par le circuit 21 sur ses bornes F et G est une copie amplifiée du signal alternatif propagé par le dispositif maître M sur le chemin de puissance de la batterie. En pratique, la fréquence de résonance de l'ensemble résonant est essentiellement fonction de la capacité CA et de l'inductance Lc₁₀.

Le circuit 21 comprend par exemple un circuit de modulation du signal alternatif vu sur ses bornes F et G, lui permettant d'émettre des données à destination du dispositif maître M, via le chemin de puissance de la batterie. Les données émises par le circuit 21 peuvent être un numéro d'identification contenu dans une mémoire du circuit 21, une mesure de température réalisée par un capteur du circuit 21, ou toutes autres données. Pour moduler le signal alternatif propagé sur le chemin de puissance de la batterie, le circuit 21 peut par exemple faire varier son impédance propre, entraînant une variation d'amplitude du signal alternatif propagé sur le chemin de puissance de la batterie. Tout autre procédé de modulation adapté pourra cependant être utilisé (modulation de fréquence, modulation de phase, etc.). Le circuit 21 peut en outre comprendre un circuit de démodulation du signal alternatif vu sur ses bornes F et G, de façon à permettre une communication bidirectionnelle entre le dispositif maître M et le dispositif esclave S.

Pour son alimentation en énergie électrique, le circuit 21 peut comprendre un bloc d'alimentation (non représenté), comportant des moyens de redressement du signal alternatif vu par les bornes F et G et de fourniture d'une tension continue redressée aux bornes d'un condensateur. Ceci permet que le circuit 21 puise son énergie électrique d'alimentation non pas directement dans la cellule c_{10'} mais dans le signal alternatif émis par le lecteur M (étant entendu que le lecteur M peut être alimenté soit par la batterie 14 soit par une source externe).

Dans un mode de réalisation préféré, on tire profit du fait qu'il existe déjà de nombreux capteurs ou autres dispositifs électroniques (par exemple d'identification) adaptés à communiquer par ondes radio avec un lecteur distant, généralement selon des protocoles normalisés. Il existe par exemple des capteurs équipés d'une antenne ou comprenant des bornes de connexion à une antenne, et comprenant déjà des circuits de modulation, de démodulation, ou de production d'une tension d'alimentation continue par redressement d'un signal alternatif fourni par l'antenne. On propose ici d'utiliser un capteur ou autre dispositif existant de ce type pour réaliser le circuit 21 (TAG). Si le dispositif existant comprend déjà une antenne, cette antenne est préalablement retirée, sinon, le dispositif existant peut être utilisé tel quel. Les bornes F et G par lesquelles le dispositif existant est connecté aux condensateurs CI et CA sont les bornes normalement destinées à être connectées à une antenne. Le dispositif existant peut être utilisé sans autre modification car, du point de vue du capteur, il est indifférent que le signal alternatif vu sur les bornes F et G soit propagé depuis ou vers le dispositif maître par les airs (par l'intermédiaire d'une antenne) ou par le chemin de puissance de la batterie.

A titre d'exemple, on peut utiliser, pour réaliser les dispositifs esclaves, des capteurs ou autres dispositifs électroniques normalement destinés à être utilisés dans des systèmes de communication sans contact de type RFID (de l'anglais "Radio Frequency Identification" - identification par fréquence radio). Par exemple, on peut utiliser des dispositifs adaptés à fonctionner selon un protocole de communication décrit dans la norme ISO 15693, visant normalement la communication sans contact par ondes radio sur une fréquence porteuse à 13,56 MHz. La fréquence du signal alternatif émis par le dispositif maître M est alors réglée à 13,56 MHz, et la capacité d'accord CA du dispositif esclave S est choisie de façon que la fréquence de résonance de l'ensemble résonant comprenant le dispositif esclave S et la cellule c₁₀ soit d'approximativement 13,56 MHz.

De même que le dispositif esclave S, le dispositif maître M peut être réalisé à partir d'un lecteur existant comportant un générateur de signal alternatif destiné à être relié à une antenne, et des moyens de modulation et/ou démodulation de signaux émis et/ou reçus par l'antenne. Si le lecteur existant comporte déjà une antenne, cette antenne est préalablement retirée. Les bornes V+ et V- de la batterie peuvent être connectées à la place de l'antenne par l'intermédiaire de condensateurs d'isolement ou de découplage permettant d'éviter que la tension continue de la batterie ne soit appliquée au lecteur.

Les modes de réalisation décrits ne se limitent bien entendu pas à la réutilisation d'éléments existants de systèmes de communication sans contact par ondes radio. On pourra par exemple aussi prévoir un protocole de communication spécifique, et réaliser des dispositifs maître et esclave(s) spécifiquement dédiés à la mise en oeuvre de ce protocole. En particulier, toute fréquence de travail autre que 13,56 MHz pourra être utilisée. Les inventeurs ont constaté que les fréquences comprises entre 30 kHz et 30 MHz sont particulièrement adaptées à la mise en oeuvre de communications robustes via le chemin de puissance de la batterie.

La figure 3 est un schéma électrique illustrant une variante de réalisation du dispositif esclave S de la figure 2. Le dispositif de la figure 3 diffère du dispositif de la figure 2 en ce que le circuit 21 est alimenté non pas par redressement du signal alternatif vu sur ses bornes F et G, mais par une tension continue prélevée directement aux bornes de la cellule à laquelle le dispositif S est connecté. Outre les bornes F et G d'application d'un signal alternatif, le circuit 21 comporte des bornes H et I d'application d'une tension d'alimentation continue. Les bornes H et I sont connectées respectivement aux bornes A et B du dispositif S, c'est-à-dire en amont des condensateurs d'isolement CI. Ainsi, lorsque le dispositif S est connecté aux bornes d'une cellule de la batterie, les bornes H et I reçoivent directement la tension continue délivrée par cette cellule.

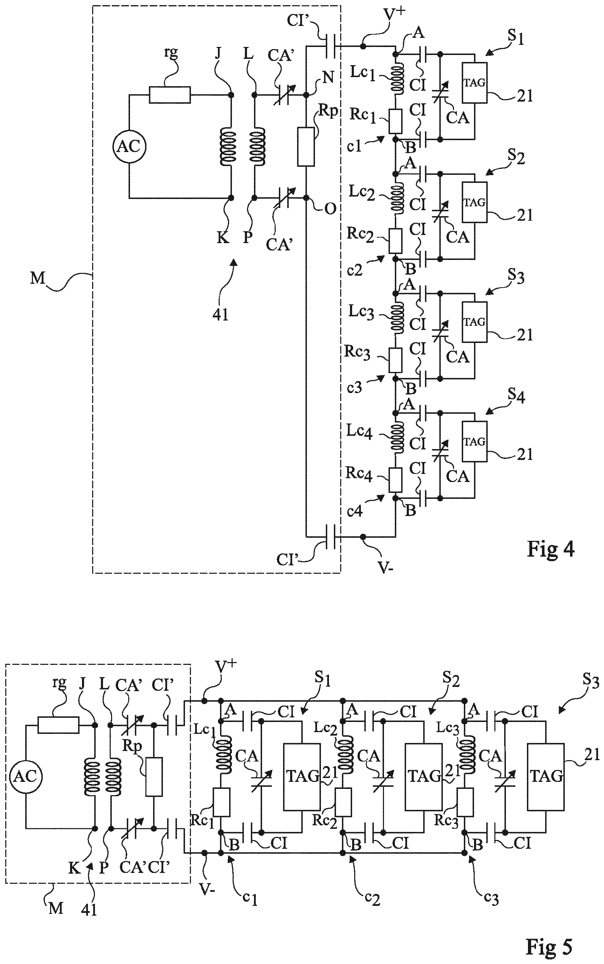

La figure 4 est un schéma électrique illustrant un exemple de réalisation d'un système de communication entre un dispositif maître M et des dispositifs esclaves Sᵢ dans une batterie électrique dans laquelle des cellules élémentaires cᵢ sont reliées en série entre les bornes V+ et V- de la batterie (un dispositif esclave par cellule, i allant de 1 à 4 dans cet exemple). Les dispositifs esclaves S₁ à S₄ sont par exemple des dispositifs du type décrit en relation avec la figure 2, et sont respectivement connectés en parallèle des cellules c₁ à c₄ (sur la figure 4, chaque cellule cᵢ est représentée schématiquement par une inductance Lcᵢ en série avec une résistance Rcᵢ). Alternativement, on pourra prévoir de n'équiper que certaines seulement des cellules de la batterie. En outre, on pourra prévoir de connecter un dispositif esclave Sᵢ non pas en parallèle d'une cellule élémentaire cᵢ comme cela est représenté sur les figures, mais en parallèle d'une chaîne d'au moins deux cellules élémentaires en série.

Le réglage de la résonance se fait par les capacités d'accord CA. Ce réglage dépend notamment du nombre de cellules instrumentées. Si un dispositif esclave Sᵢ est connecté en parallèle d'une chaîne de plusieurs cellules élémentaires cᵢ en série, il faudra tenir compte, pour le réglage de la résonance, de l'inductance propre et de la résistance propre de cette chaîne de cellules.

Dans l'exemple de la figure 4, le dispositif maître M est modélisé par un générateur AC de signal alternatif en série avec une résistance rg (résistance interne de générateur). Afin de réaliser un bon transfert d'énergie, il est préférable que la charge vue par le générateur à ses bornes de sortie J et K soit égale à son impédance interne rg (typiquement 50 Ohms) . Pour réaliser l'adaptation d'impédance, on peut prévoir un transformateur d'impédance 41 entre les bornes J et K de sortie du générateur AC et des bornes L et P reliées respectivement aux bornes V+ et V- de la batterie. Dans cet exemple, la borne L est relié à la borne V+ par l'intermédiaire d'un condensateur d'accord CA' en série avec un condensateur d'isolement CI', et la borne O est reliée à la borne V- par l'intermédiaire d'un second condensateur CA' en série avec un second condensateur CI' .

Idéalement, l'impédance (charge) vue par le transformateur 41 à ses bornes L et P doit être purement réelle. Les condensateurs d'accord CA', par exemple des condensateurs à capacité variable, sont prévus pour compenser les inductances parasites liées aux éléments de connexion entre les cellules de la batterie.

Les condensateurs CI' d'isolement ou de découplage sont prévus pour empêcher que la tension continue de la batterie ne soit appliquée aux bornes L et P du transformateur d'impédance 41.

Une résistance de protection Rp peut être prévue entre un noeud N commun au premier condensateur CA' et au premier condensateur CI', et un noeud O commun au second condensateur CA' et au second condensateur CI'. La résistance Rp permet en particulier de décharger les condensateurs d'isolement CI' en cas de déconnexion de la batterie.

Outre les éléments représentés sur la figure 4, le dispositif maître M peut comprendre des moyens de modulation et/ou de démodulation des signaux alternatifs émis et/ou reçus par l'intermédiaire du chemin de puissance de la batterie, et des moyens de traitement pour coder et/ou décoder les messages émis et/ou reçus.

La figure 5 est un schéma électrique illustrant un exemple de réalisation d'un système de communication entre un dispositif maître M et des dispositifs esclaves Sᵢ dans une batterie électrique dans laquelle des cellules élémentaires cᵢ sont reliées en parallèle entre les bornes V+ et V- de la batterie (un dispositif esclave par cellule, i allant de 1 à 3 dans cet exemple). Dans l'exemple représenté, le dispositif maître M et les dispositifs esclaves Sᵢ sont du même type que dans l'exemple de la figure 4, mais les dispositifs esclaves Sᵢ du système de la figure 5 sont reliés en parallèle entre les bornes V+ et V-, et non pas en série comme dans le système de la figure 4. Le réglage de résonance se fait par les capacités d'accord CA.

Un avantage du mode de communication proposé est qu'il permet des communications fiables entre un dispositif maître et au moins un dispositif esclave dans une batterie électrique.

En particulier, ce mode de communication est peu sensible aux perturbations de l'environnement.

De plus, il n'est pas nécessaire de prévoir des câbles allant de l'intérieur vers l'extérieur de la batterie.

En outre, les résonateurs utilisés, côté dispositifs esclaves, pour communiquer avec le dispositif maître, utilisent l'inductance propre des cellules de la batterie comme élément résonant. Ceci permet une économie de composants (inductances).

Des modes de réalisation particuliers ont été décrits. Diverses variantes et modifications apparaîtront à l'homme de l'art.

En particulier, il est connu qu'une batterie peut être divisée en plusieurs modules comprenant chacun une pluralité de cellules reliées en série ou en parallèle entre deux noeuds ou bornes de contact du module, les modules étant reliés en série ou en parallèle entre les bornes de la batterie. Bien que cela n'ait pas été mentionné ci-dessus, l'homme de l'art saura ajouter de la modularité au système de communication décrit ci-dessus. Par exemple, dans une batterie à plusieurs modules, on pourra prévoir, pour chaque module ou groupe de modules, un dispositif maître d'un premier rang, un dispositif maître de rang supérieur étant prévu pour communiquer avec les dispositifs maîtres de rang inférieur (réseau arborescent). De façon générale, l'homme de l'art saura adapter toute structure de réseau connue au mode de communication décrit ci-dessus. Le cas échéant, l'homme de l'art saura prévoir des protocoles de communication adaptés. En particulier, l'homme de l'art pourra prévoir d'utiliser plusieurs fréquences porteuses dans une même batterie.

De plus, bien que la figure 1 représente un dispositif esclave S situé à l'extérieur d'une cellule élémentaire de la batterie, le mode de communication décrit permet également de prévoir des capteurs à l'intérieur des cellules, par exemple un capteur de la température de l'électrolyte. Le système de communication proposé est alors particulièrement avantageux puisqu'il permet de se passer de toute connexion spécifique (autre que les bornes de puissance de la cellule) à l'extérieur de la cellule.

## Revendications

1. Système comportant :
une batterie (14) dans laquelle une pluralité de cellules élémentaires (cᵢ) sont reliées entre deux premiers noeuds (V+, V-) ;
un premier dispositif (M) adapté à appliquer un signal alternatif auxdits premiers noeuds (V+, V-) ;
au moins un deuxième dispositif (S, Sᵢ) connecté à deux deuxièmes noeuds (A, B) de la pluralité de cellules ; et
au moins un ensemble résonant dont un élément inductif comporte l'inductance propre (Lcᵢ) de la batterie entre lesdits deuxièmes noeuds (A, B),
le système étant **caractérisé en ce que** ledit deuxième dispositif est adapté à communiquer avec le premier dispositif par modulation, sensiblement à la fréquence de résonance dudit ensemble résonnant, du signal alternatif vu par les deuxièmes noeuds.

2. Système selon la revendication 1, dans lequel ledit au moins un ensemble résonant comporte au moins un élément capacitif (CA) dudit au moins un deuxième dispositif (S, Sᵢ).

3. Système selon l'une quelconque des revendications 1 à 3, dans lequel la fréquence de résonance dudit ensemble résonant est comprise entre 30 kHz et 30 MHz.

4. Système selon l'une quelconque des revendications 1 à 4, dans lequel lesdits deuxièmes noeuds (A, B) sont deux bornes de puissance d'une même cellule élémentaire (cᵢ).

5. Système selon l'une quelconque des revendications 1 à 5, dans lequel ledit au moins un deuxième dispositif (S, Sᵢ) comprend un circuit de traitement (21, TAG) comportant deux troisièmes noeuds (F, G), ledit au moins un deuxième dispositif comportant des condensateurs (CI) d'isolement entre lesdits troisièmes noeuds (F, G) et lesdits deuxièmes noeuds (A, B).

6. Système selon l'une quelconque des revendications 1 à 5, dans lequel le premier dispositif (M) comprend un générateur (AC) alternatif et un transformateur d'impédance (41) entre ledit générateur (AC) et lesdits premiers noeuds (V+, V-).

7. Système selon la revendication 6, dans lequel le premier dispositif comprend des condensateurs (CA) d'accord en fréquence et des condensateurs (CI) d'isolement entre ledit transformateur (41) et lesdits premiers noeuds (V+, V-).

8. Système selon l'une quelconque des revendications précédentes, dans lequel le deuxième dispositif (S, Sᵢ) est situé à l'intérieur d'une cellule élémentaire (ci) de la batterie.

9. Système selon la revendication précédente, dans lequel le deuxième dispositif (S, Sᵢ) comprend un capteur apte à mesurer la température de l'électrolyte de la cellule (ci) dans laquelle il est situé.

10. Procédé de communication, dans une batterie (14) dans laquelle une pluralité de cellules élémentaires (cᵢ) sont reliées entre deux premiers noeuds (V+, V-), entre un premier dispositif (M) relié auxdits premiers noeuds (V+, V-) et au moins un deuxième dispositif (S, Sᵢ) connecté à deux deuxièmes noeuds (A, B) de ladite pluralité de cellules, ce procédé étant **caractérisé en ce qu'**il comporte les étapes suivantes :
côté premier dispositif (M), appliquer un signal alternatif auxdits premiers noeuds (V+, V-) ; et
côté deuxième dispositif (S, Sᵢ), recevoir ledit signal alternatif par l'intermédiaire d'au moins un ensemble résonant dont un élément inductif comporte l'inductance propre (Lcᵢ) de la batterie entre lesdits deuxièmes noeuds (A, B), et moduler ledit signal.

## Patentansprüche

1. System, umfassend:
eine Batterie (14), bei der eine Vielzahl von Elementarzellen (cᵢ) zwischen zwei ersten Knoten (V+, V-) angeschlossen sind;
eine erste Vorrichtung (M), die dazu geeignet ist, ein Wechselstromsignal an die ersten Knoten (V+, V-) anzulegen;
mindestens eine zweite Vorrichtung (S, Sᵢ), die mit zwei zweiten Knoten (A, B) der Vielzahl von Zellen verbunden ist; und
mindestens eine schwingungsfähige Einheit, bei der ein induktives Element die Eigeninduktivität (Lcᵢ) der Batterie zwischen den zweiten Knoten (A, B) umfasst,
wobei das System **dadurch gekennzeichnet ist, dass** die zweite Vorrichtung dazu geeignet ist, durch Modulation des Wechselstromsignals, das von den zweiten Knoten gesehen wird, im Wesentlichen mit der Resonanzfrequenz der schwingungsfähigen Einheit mit der ersten Vorrichtung zu kommunizieren.

2. System nach Anspruch 1, bei dem die mindestens eine schwingungsfähige Einheit mindestens ein kapazitives Element (CA) der mindestens einen zweiten Vorrichtung (S, Sᵢ) umfasst.

3. System nach einem der Ansprüche 1 bis 3, bei dem die Resonanzfrequenz der schwingungsfähigen Einheit zwischen 30 kHz und 30 MHz umfasst.

4. System nach einem der Ansprüche 1 bis 4, bei dem die zweiten Knoten (A, B) zwei Leistungsanschlüsse einer selben Elementarzelle (cᵢ) sind.

5. System nach einem der Ansprüche 1 bis 5, bei dem die mindestens eine zweite Vorrichtung (S, Sᵢ) einen Verarbeitungsschaltkreis (21, TAG) umfasst, der zwei dritte Knoten (F, G) umfasst, wobei die mindestens eine zweite Vorrichtung Isolationskondensatoren (CI) zwischen den dritten Knoten (F, G) und den zweiten Knoten (A, b) umfasst.

6. System nach einem der Ansprüche 1 bis 5, bei dem die erste Vorrichtung (M) einen Wechselstromgenerator (AC) und einen Impedanztransformator (41) zwischen dem Generator (AC) und den ersten Knoten (V+, V-) umfasst.

7. System nach Anspruch 6, bei dem die erste Vorrichtung Kondensatoren (CA) übereinstimmender Frequenz und Isolationskondensatoren (CI) zwischen dem Transformator (41) und den ersten Knoten (V+, V-) umfasst.

8. System nach einem der vorhergehenden Ansprüche, bei dem sich die zweite Vorrichtung (S, S₁) im Inneren einer Elementarzelle (ci) der Batterie befindet.

9. System nach dem vorhergehenden Anspruch, bei dem die zweite Vorrichtung (S, Sᵢ) einen Sensor umfasst, der dazu fähig ist, die Temperatur des Elektrolyten der Zelle (ci), in der er sich befindet, zu messen.

10. Kommunikationsverfahren in einer Batterie (14), bei der eine Vielzahl von Elementarzellen (cᵢ) angeschlossen sind zwischen zwei ersten Knoten (V+, V-) zwischen einer ersten Vorrichtung (M), die an die ersten Knoten (V+, V-) angeschlossen ist, und mindestens einer zweiten Vorrichtung (S, Sᵢ), die mit zwei zweiten Knoten (A, B) der Vielzahl von Zellen verbunden ist, wobei das Verfahren **dadurch gekennzeichnet ist, dass** es die folgenden Schritte umfasst:
auf Seiten der ersten Vorrichtung (M) Anlegen eines Wechselstromsignals an die ersten Knoten (V+, V-); und
auf Seiten der zweiten Vorrichtung (S, Sᵢ) Empfangen des Wechselstromsignals durch mindestens eine schwingungsfähige Einheit, bei der ein induktives Element die Eigeninduktivität (Lcᵢ) zwischen den zweiten Knoten (A, B) umfasst, und Modulieren des Signals.

## Claims

1. System comprising:
a battery (14) in which a plurality of elementary cells (cᵢ) are connected between two first nodes (V+, V-);
a first device (M) suitable for applying an alternating signal to said first nodes (V+, V-);
at least one second device (S, Sᵢ) connected to two second nodes (A, B) of the plurality of cells; and
at least one resonant assembly, of which an inductive element comprises the inductor (Lcᵢ) belonging to the battery between said second nodes (A, B),
the system being **characterized in that** said second device is suitable for communicating with the first device by modulation, substantially at the resonance frequency of said resonant assembly, of the alternating signal seen by the second nodes (A, B).

2. System according to Claim 1, wherein said at least one resonant assembly has at least one capacitive element (CA) of said at least one second device (S, Sᵢ).

3. System according to any one of Claims 1 to 3, wherein the resonance frequency of said resonant assembly is between 30 kHz and 30 MHz.

4. System according to any one of Claims 1 to 4, wherein said second nodes (A, B) are two power terminals of the same elementary cell (cᵢ).

5. System according to any one of Claims 1 to 5, wherein said at least one second device (S, Sᵢ) comprises a processing circuit (21, TAG) comprising two third nodes (F, G), said at least one second device comprising isolation capacitors (CI) between said third nodes (F, G) and said second nodes (A, B).

6. System according to any one of Claims 1 to 5, wherein the first device (M) comprises an alternating generator (AC) and an impedance transformer (41) between said generator (AC) and said first nodes (V+, V-) .

7. System according to Claim 6, wherein the first device comprises frequency tuning capacitors (CA) and isolation capacitors (CI) between said transformer (41) and said first nodes (V+, V-).

8. System according to any one of the preceding claims, wherein the second device (S, Sᵢ) is arranged within an elementary cell (cᵢ) of the battery.

9. System according to the preceding claim, wherein the second device (S, Sᵢ) comprises a sensor able to measure the temperature of the electrolyte of the cell (cᵢ) in which it is arranged.

10. Method for communicating, in a battery (14) in which a plurality of elementary cells (cᵢ) are connected between two first nodes (V+, V-), between a first device (M) connected to said first nodes (V+, V-) and at least one second device (S, Sᵢ) connected to two second nodes (A, B) of said plurality of cells, this method being **characterized in that** it comprises the following steps:
on the side of the first device (M), applying an alternating signal to said first node (V+, V-); and
on the side of the second device (S, Sᵢ), receiving said alternating signal via at least one resonant assembly, of which an inductive element comprises the inductor (Lcᵢ) belonging to the battery between said second nodes (A, B), and modulating said signal.
